Europäisches Patentamt

European Patent Office

Office européen des brevets

(11) Veröffentlichungsnummer: **0 393 712**

**A1**

# (12) EUROPÄISCHE PATENTANMELDUNG

(21) Anmeldenummer: **90107562.2**

(22) Anmeldetag: **20.04.90**

(51) Int. Cl.5: **H03K 3/10, G03F 7/28**

(30) Priorität: **21.04.89 DE 3913116**

(43) Veröffentlichungstag der Anmeldung:
**24.10.90 Patentblatt 90/43**

(84) Benannte Vertragsstaaten:
**CH DE ES FR GB IT LI NL SE**

(71) Anmelder: **DU PONT DE NEMOURS
(DEUTSCHLAND) GMBH
Du Pont Strasse 1
D-6380 Bad Homburg(DE)**

(72) Erfinder: **Dudek, Dietmar, Dr.
Philipp-Reis-Strasse 6
D-6370 Oberursel(DE)**
Erfinder: **Pfeiffer, Thomas, Dr.
25 Glenbarry Drive
Wilmington, Delaware 19808(US)**

(54) Verfahren zur Herstellung von elektrisch leitfähingen Mustern.

(57)

1. Die Herstellung von Leiterbahnmustern auf keramischen Substraten nach dem Pulververfahren erfordert spezielle Pulver, welche die für die Steuerung der Haftung und des Sintervorgangs notwendigen Zusatzelemente enthalten. Die Herstellung dieser Pulver ist kompliziert ist und ihre Zusammensetzung kann sich beim Auftragen verändern. Es soll ein Verfahren angegeben werden, welches die Verwendung handelsüblicher Pulver, die nur aus den Leitmetallen bestehen, ermöglicht.

2. Bei der Durchführung des Pulververfahrens wird das keramische Substrat mit einer zumindest zeitweise klebrigen Beschichtung versehen, welche Verbindungen der Zusatzelemente enthält.

3. Herstellung gedruckter Schaltungen auf keramischen Substraten, beispielsweise für Hybridschaltkreise.

EP 0 393 712 A1

## Verfahren zur Herstellung von elektrisch leitfähigen Mustern

Die Erfindung betrifft ein Verfahren zur Herstellung von elektrisch leitfähigen Mustern auf keramischen Substraten, wie sie beispielsweise als elektrische Schaltkreise in Hybridanordnungen verwendet werden.

Aus der deutschen Auslegeschrift 11 07 743 und der kanadischen Patentschrift 11 55 967 ist bekannt, elektrisch leitfähige Muster auf der Oberfläche von keramischen Substraten nach dem sog. Pulververfahren herzustellen. Dabei wird auf der Oberfläche des Substrates ein klebriges Muster erzeugt und danach die Oberfläche mit einem Metallpulver behandelt. Durch eine Wärmebehandlung kann dann das klebrige Material entfernt und das Metallpulver zu einem zusammenhängenden Muster von Leiterbahnen gesintert werden.

Im allgemeinen ist es notwendig, daß neben dem eigentlichen Leitmetall, aus dem die Leiterbahnen gebildet werden, in dem System noch weitere Zusatzelemente, ggf. in Form geeigneter Verbindungen, zugegen sind, um die Haftung der gemusterten Metallschicht auf dem Substrat nach dem Sintern zu ermöglichen und um den Sintervorgang so zu steuern, daß Leiterbahnen mit glatter Oberfläche und gleichmäßigem Querschnitt entstehen. Man unterscheidet zwei Mechanismen für das Zustandekommen der Haftung. Bei der Glasbindung bilden die Oxide der Zusatzelemente ein Glas, welches bei der Brenntemperatur schmilzt und das Substrat mit der Leiterbahn nach dem Erkalten teils durch Adhäsion, teils durch Formschluß verbindet, während bei der reaktiven oder Oxidbindung durch Festkörperreaktion dieser Oxide mit Substrat und Leitmetall eine bindende Zwischenphase entsteht. Die Auswahl der Zusatzelemente richtet sich dementsprechend nach dem Leitmetall und nach der Art des Substrats. Geeignete Kombinationen sind aus der Dickfilmtechnik bekannt. Beispielsweise sind in der deutschen Patentschrift 25 43 922 haftvermittelnde Verbindungen für Gold und Silber auf Aluminiumoxid, Berylliumoxid und Saphir·genannt, die Cadmium, Kupfer, Blei, Titan, Zirkonium, Silicium, Bor und Alkalimetalle enthalten. Es ist auch bekannt, dekorative Goldüberzüge auf keramischen Substraten durch Verbindungen von Rhodium, Wismut und Silber so zu modifizieren, daß beim Sintern gleichmäßige Schichten mit guter Haftung und glänzender Oberfläche entstehen (s. z.B. Ullmann's Enzyklopädie der technischen Chemie, 4. Auflage, Band 14, Seite 10).

Die Zusatzelemente sollen demnach ihre Wirkung hauptsächlich an der Grenzfläche zwischen Substrat und Leitmetall bzw. an der Oberfläche des Leitmetalls entfalten. Es ist im allgemeinen nachteilig, wenn sie in das Leitmetall eindringen und mit diesem Mischungen bilden, weil dadurch die spezifische Leitfähigkeit in der Leiterbahn herabgesetzt wird.

In der deutschen Patentschrift 38 06 515 wird ein Verfahren beschrieben, mit dem man metallhaltige Pulver für das Pulververfahren herstellen kann, welche geeignete Verbindungen der erforderlichen Zusatzelemente in homogener Verteilung enthalten. Durch Verwendung der so gewonnenen Pulver lassen sich zwar feine Leiterbahnen guter Beschaffenheit und Leitfähigkeit herstellen. Das Herstellungsverfahren für die Pulver ist jedoch relativ kompliziert. Es ist auch nachteilig, daß für verschieden beschaffene Substrate und je nach der angestrebten Beschaffenheit der Leiterbahnen verschiedene Pulver hergestellt und vorrätig gehalten werden müssen.

Die Erfindung stellt sich daher die Aufgabe, ein Verfahren anzugeben, nach dem sich auf einfache Weise die für die Herstellung von elektrisch leitfähigen Mustern auf keramischen Substraten nach dem Pulverfahren für die Steuerung der Haftung und des Sinterungsvorgangs notwendigen Zusatzelemente so in das System einbringen lassen, daß sie die Leitfähigkeit des Leitmetalls nicht beeinträchtigen.

Diese Aufgabe wird durch das Verfahren nach dem Hauptanspruch gelöst.

Für die Erzeugung der wenigstens zeitweise klebrigen Schicht auf dem Substrat kann beispielsweise ein geeigneter Klebstoff dienen, der mittels Siebdruck auf die Substratoberfläche aufgebracht wird und die Zusatzelemente enthält. Wegen des höheren Auflösungsvermögens und der daraus resultierenden wesentlich höheren Feinheit der metallischen Muster wird jedoch bevorzugt eine lichtempfindliche Schicht verwendet, deren Klebrigkeit sich bei Belichtung ändert. Geeignete Verbindungen sind in den deutschen Patentschriften 12 10 321, 19 04 059, 19 44 311, 27 28 209, 28 15 894, 30 23 247, 34 29 615 und anderen beschrieben. Das Verfahren läßt sich besonders einfach mit guten Ergebnissen ausführen, wenn als lichtempfindliche Verbindungen 1,4-Dihydropyridinverbindungen nach der Lehre der DE-PS 34 29 615 verwendet werden.

Wenn es gelingt, alle für die Steuerung der Haftung und des Sinterverhaltens notwendigen Zusatzelemente in die lichtempfindliche Schicht zu inkorporieren, können zur Erzeugung des Pulverbildes solche Pulver verwendet werden, die nur aus dem Leitmetall bestehen. Eine besondere Behandlung der Metallpulver, beispielsweise nach der Lehre der DE-PS 38 06 515, ist dann nicht mehr notwendig. Da diese Ausführungsform den Gesamtprozeß der Leiterbahnherstellung stark vereinfacht, wird sie besonders bevorzugt.

Die Auswahl der Zusatzelemente richtet sich nach der Art der für den Aufbau der metallischen Muster verwendeten Metalle und nach der Art des Substrats. Der Fachmann kann hierzu den Stand der Technik sowie seine Erfahrungen auf dem Gebiet der Dickfilmtechnik heranziehen.

Besonders bevorzugte Leitmetalle für die Erzeugung der Leiterbahnmuster sind Gold, Silber, Platin, Palladium oder Kupfer. Diese Metalle werden als Pulver mit einer mittleren Teilchengröße von 0,1 bis 5 μm in reiner Form oder auch als Gemisch oder als Pulver ihrer Legierungen angewendet.

Für diese Leitmetalle werden als Zusatzelemente zur Steuerung der Haftung und des Sinterverhaltens bevorzugt Wismut, Cadmium, Blei, Kupfer, Rhodium und Bor verwendet.

Ein geeignetes Lösungsmittel, in dem sowohl die lichtempfindlichen Substanzen als auch die Verbindungen der Zusatzelemente und ggf. die weiteren Hilfsstoffe homogen gelöst werden können, findet der Fachmann in der Regel ohne Schwierigkeiten durch einfache Vorversuche. Es können auch mehrere miteinander verträgliche Lösungsmittel für die einzelnen Komponenten gewählt werden und die Teillösungen miteinander vermischt werden. Beispielsweise kann man die lichtempfindlichen 1,4-Dihydropyridine in Methylethylketon und die Salze der Zusatzelemente in Eisessig lösen und beide Lösungen vermischen. Etwa auftretende Niederschläge können beispielsweise mit Ultraschall dispergiert werden. Ein bevorzugtes Verfahren besteht darin, zunächst die Salze der Zusatzelemente in einem stärker polaren Lösungsmittel wie Essigsäure zu lösen, dann ein weniger polares Lösungsmittel, beispielsweise Methylethylketon zuzugeben und schließlich die lichtempfindlichen Komponenten in diesem Gemisch zu lösen.

Für die Festlegung des Mengenverhältnisses zwischen den lichtempfindlichen Substanzen und den Verbindungen der Zusatzelemente muß man in Betracht ziehen, welche Schichtstärke die lichtempfindliche Komponente im klebrigen Zustand haben muß, um die gewünschte Menge Metallpulver festhalten zu können und wie hoch der Anteil der Zusatzelemente im Verhältnis zum Leitmetall sein muß. Diese Werte können aus Vorversuchen ermittelt werden. Der praktisch wichtige Bereich für das Flächenauftragsgewicht des Leitmetalls liegt zwischen 3 und 15 mg/cm$^2$, der Anteil der Zusatzelemente bezogen auf das Leitmetall üblicherweise zwischen 0,1 und 5 %. Erfahrungsgemäß läßt sich dieses Flächenauftragsgewicht erreichen, wenn die Schichtstärke des lichtempfindlichen Materials 0,1 bis 5 μm beträgt.

Überraschenderweise wurde festgestellt, daß die Verbindungen der Zusatzelemente der lichtempfindlichen, bei Belichtung klebrig werdenden Schicht einverleibt werden konnten, ohne daß deren Lichtempfindlichkeit dadurch wesentlich herabgesetzt wurde.

Wärmebeständige Substrate sind, dem derzeitigen Stand der Technik entsprechend, bevorzugt Formkörper aus Aluminiumoxid. Es können jedoch auch andere bekannte Substrate, beispielsweise aus Berylliumoxid, Aluminiumnitrid, Siliciumdioxid oder emailliertem Metall, Anwendung finden.

Die verwendeten Pulver sind vorzugsweise reine Pulver der für den Aufbau der Leiterbahnmuster ausgewählten Metalle oder Legierungen. Anstelle von Legierungen können selbstverständlich auch Gemische der entsprechenden Metallpulver verwendet werden. Ebenfalls geeignet sind metallhaltige Pulver, die entsprechend der Lehren der kanadischen Patentschrift 11 55 967 oder der DE-PS 38 06 515 hergestellt wurden und die notwendigen Zusatzelemente völlig oder zum Teil enthalten.

Die keramischen Substrate mit den durch das Auftragen der Pulver auf die klebrigen Oberflächenbereiche entstandenen Pulverbildern werden in üblicher Weise gebrannt. Dabei werden die organischen Bestandteile der zumindest zeitweise klebrigen Schichten durch Verdampfen oder durch Oxidation entfernt und gleichzeitig die Pulverbilder zu den gewünschten Leiterbahnzügen gesintert.

Bei der Ausarbeitung des erfindungsgemäßen Verfahrens wurde überraschenderweise festgestellt, daß sinterungssteuernde Zusatzelemente, wie beispielseise Rhodium für Gold, wenn sie erfindungsgemäß in das System eingebracht werden, ebenso gut wirken wie bei der Inkorporierung in das Pulver nach der DE-PS 38 06 515, obwohl sie zunächst nur in der Grenzschicht zwichen Pulver und Substrat und nicht auf der Oberfläche der Pulverteilchen vorhanden sind.

Die spezifische Leitfähigkeit der erfindungsgemäß hergestellten Leiterbahnen ist ausgezeichnet und entspricht der von Dünnfilmleitern. Die Oberflächen der Leiterbahnen sind glänzend und so rein, daß beispielsweise Gold sich sehr gut preßschweißen läßt.

Die zur Steuerung des Sinterns und der Haftung erforderlichen Zusatz elemente können vollständig in der Beschichtung des Substrats untergebracht werden. So ist es möglich, zum Tonen der klebrigen Muster reine Metallpulver zu verwenden, die keiner besonderen Vorbehandlung unterzogen worden sind. Da solche Pulver handelsüblich sind, wird der Prozeß gegenüber dem Stand der Technik sehr vereinfacht. In diesem Fall ergibt sich als weiterer Vorteil, daß das Tonerpulver im Verlauf des Gebrauchs in seiner Zusammensetzung kon

stant bleibt, da es keine Komponenten enthält, die selektiv an der klebrigen Oberfläche haften könnten.

Die Erfindung wird angewendet bei der Herstellung von Leiterbahnmustern auf keramischen Substraten, beispielsweise für Hybridschaltungen. Sie kann auch für andere Zwecke, z.B. metallische Dekorationen, eingesetzt werden.

Ausführungsbeispiel 1:

600 mg Wismutnitrat wurden in 1,5 ml Essigsäure gelöst. Diese Lösung wurde mit 8 ml Methylethylketon verdünnt und 0,5 g des Dimethyl- und 1,5 g des Diethylesters der 2,6-Dimethyl-4-(2'-nitrophenyl)-1,4-dihydropyridin-3,5-dicarbonsäure darin aufgelöst. 5x5 cm große Plättchen aus Aluminiumoxid (99%) wurden mit diesem Gemisch beschichtet und getrocknet. Das Auftragsgewicht der trockenen Schicht betrug etwa 0,2 mg/cm². Auf diese Schicht wurde mit einer Quecksilberdampflampe ein Testmuster aufbelichtet, welches Leiterbahnen von 25 μm Breite und quadratische Flächen von 2x2 mm für die Bondprüfung aufwies. Auf der belichteten Schicht wurde mit reinem Goldpulver von 1,5 μm mittlerer Teilchengröße ein Pulverbild mit einem Flächenauftragsgewicht von etwa 8 mg/cm² nach dem Verfahren der DE-PS 37 36 391 erzeugt. Danach wurden die Plättchen bei 900 °C 10 min gebrannt. Es bildeten sich glatte, hell glänzende Leiterbahnen mit gute Haftung zum Substrat und guter Bondbarkeit. Der Abreißversuch mit aufgebondeten 37,5 μm starken Golddrähten ergab eine mittlere Abrißkraft von 16±2 cN. Der spezifische Widerstand der Leiterbahnen betrug 2,8 μΩcm. Ein Vergleichsversuch nach dem Verfahren der deutschen Patentanmeldung 38 06 515 mit einem Pulver, welches aus Goldpulver unter Zusatz von Wismutverbindungen hergestellt worden war, ergab demgegenüber eine mittlere Abrißkraft von 17 cN und eine spezifische Leitfähigkeit von 3,2 μΩcm.

Ausführungsbeispiel 2:

600 mg Wismut-(III)-nitrat wurden in 1,5 ml Essigsäure gelöst und mit 8 ml Methylethylketon verdünnt. In dieser Mischung wurden 2 g des Diethylesters der 2,6-Dimethyl-4-(2'-nitrophenyl)-1,4-dihydropyridin-3,5-dicarbonsäure aufgelöst und mit dieser Lösung Probeplättchen (5x5 cm) aus Aluminiumoxid beschichtet. Diese Plättchen wurden wie im Ausführungsbeispiel 1 belichtet, mit dem unten genannten Metallpulver behandelt und gebrannt. Man erhielt scharf begrenzte Leiterbahnen mit glatten Rändern und glänzender Oberfläche. Die Prüfung des spezifischen Widerstandes ergab folgende Werte:

Probe A: Goldpulver, 1,5 μm Teilchengröße: 2,45 μΩcm.

Probe B: Silberpulver, 1,3 μm Teilchengröße: 1,9 μΩcm.

Probe C: Platinpulver, 1,5 μm Teilchengröße: 19 μΩcm.

**Ansprüche**

1. Verfahren zur Herstellung von elektrisch leitfähigen Mustern nach dem Pulververfahren unter Verwendung einer wenigstens zeitweise klebrigen Schicht und eines metallhaltigen Pulvers, wobei das Pulverbild durch Wärmebehandlung in Gegenwart von Zusatzelementen, welche die Haftung der Leiterbahnen am Substrat und das Sinterverhalten des Leitmetalls steuern, oder von Verbindungen solcher Zusatzelemente in ein Leiterbahnmuster umgewandelt wird,
dadurch gekennzeichnet, daß
die wenigstens zeitweise klebrige Schicht Verbindungen der Zusatzelemente enthält.

2. Verfahren nach Anspruch 1,
dadurch gekennzeichnet, daß
die wenigstens zeitweise klebrige Schicht eine lichtempfindliche Schicht ist, deren Klebrigkeit sich bei Belichtung ändert.

3. Verfahren nach Anspruch 2,
dadurch gekennzeichnet, daß
die lichtempfindliche Schicht 1,4-Dihydropyridinverbindungen enthält.

4. Verfahren nach Anspruch 1 bis 3,
dadurch gekennzeichnet, daß
das metallhaltige Pulver nur aus Leitmetall besteht und keine Zusatzelemente enthält.

5. Verfahren nach Anspruch 1 bis 4,
dadurch gekennzeichnet, daß
als Leitmetalle Gold, Silber, Platin, Palladium oder Kupfer in reiner Form oder in Form von Mischungen oder Legierungen verwendet werden.

6. Verfahren nach Anspruch 5,
dadurch gekennzeichnet, daß
die in der lichtempfindlichen Schicht enthaltenen Verbindungen der Zusatzelemente Verbindungen des Wismuts, Cadmiums, Bleis, Kupfers, Bors oder Rhodiums sind.

7. Verfahren nach Anspruch 2 bis 6,
dadurch gekennzeichnet, daß
man eine Beschichtungslösung für die wenigstens zeitweise klebrige Schicht herstellt, in dem man zunächst Verbindungen der Zusatzelemente in einem stärker polaren Lösungsmittel auflöst und danach ein weniger polares Lösungsmittel und die lichtempfindlichen Komponenten zufügt.

8. Keramisches Substrat für die Erzeugung von elektrisch leitfähigen Mustern nach dem Pulververfahren mit einer lichtempfindlichen Schicht, welche durch Belichtung ihre Klebrigkeit ändert,
dadurch gekennzeichnet, daß
die lichtempfindliche Schicht Verbindungen von Zusatzelementen enthält, welche die Haftung der leitfähigen Muster am Substrat und den Sintervorgang des Leitmetalls zu steuern geeignet sind.

9. Keramisches Substrat nach Anspruch 8,
dadurch gekennzeichnet, daß
die lichtempfindliche Schicht 1,4-Dihydropyridinverbindungen enthält.

10. Keramisches Substrat nach Anspruch 8 oder 9,
dadurch gekennzeichnet, daß
die in der lichtempfindlichen Schicht enthaltenen Verbindungen der Zusatzelemente Verbindungen des Wismut, Cadmiums, Bleis, Bors oder Rhodiums sind

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | EP-A-0 224 137 (DU PONT)<br>* Seite 2, Zeilen 10-29; Ansprüche 1,2,8,9 *<br>--- | 1-3,8,9 | H 05 K 3/10<br>G 03 F 7/28 |
| A | EP-A-0 035 187 (DU PONT)<br>* Ansprüche 1,2 *<br>--- | 1-5,8 | |
| A | DE-A-3 541 427 (DU PONT)<br>* Ansprüche 1,9-11,13 *<br>--- | 1-5,8,9 | |
| A | EP-A-0 200 110 (HITACHI)<br>* Ansprüche 7-9 *<br>--- | 1,2,8 | |
| A,D | DE-A-3 429 615 (DU PONT)<br>* Seite 3, Zeile 13 - Seite 5, Zeile 10 *<br>--- | 1-5,8,9 | |
| A,D | CA-A-1 155 967 (NORTHERN TELCOM)<br>* Ansprüche 1-18 *<br>------ | 1,8 | |

RECHERCHIERTE
SACHGEBIETE (Int. Cl.5)

H 05 K 3/00
G 03 F 7/00

Der vorliegende Recherchenbericht wurde für alle Patentansprüche erstellt

| Recherchenort | Abschlußdatum der Recherche | Prüfer |
|---|---|---|
| BERLIN | 26-07-1990 | HAHN G |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPO FORM 1503 03.82 (P0403)